# EUROPEAN PATENT APPLICATION

(11) **EP 1 221 621 A1**
(43) Date of publication of application: **10.07.2002**
(21) Application number: 01128721.6
(22) Date of filing: 03.12.2001
(51) Int. Cl.: G01R 15/22, G01R 19/00, G01R 15/14

(54) **Voltage measuring apparatus**

(30) Priority: 06.12.2000 GB 0029815
(71) Applicant: Pace Micro Technology PLC, Saltaire, Shipley, BD18 3LF (GB)
(72) Inventor: Alker, Ray, West Yorkshire, HX7 8QS (GB)
(74) Representative: Wood, Graham

(57) **Abstract**

Apparatus for measuring voltage across an isolation barrier. The apparatus includes a voltage input and a voltage output and an opto-isolator provided between the voltage input and voltage output. Processing means are provided at the voltage output to measure and/or monitor pulse width. A Circuit arrangement including two transistors and two resistors is provided to allow a substantially constant current to flow through the opto-isolator.

## Description

This invention relates to apparatus for measuring DC voltages across an isolation barrier.

Telecommunications organizations worldwide require that equipment connected to their networks provides a physical isolation barrier between the equipment and the telephone network. This barrier is to prevent unsafe voltages from being applied to the network by the equipment in the event of equipment malfunction.

An opto-isolator is an electrical component which is divided into two halves, separated by a physical gap, to provide a voltage isolation barrier. The opto-isolator does this by converting incoming electrical signals to light using a light-emitting diode provided on a first half of the isolator. The light emitted from the diode is directed across the isolation gap onto the junction of a light activated transistor. Light falling onto the transistor causes it to conduct, passing current across the collector and emitter of the transistor and producing a pulse width change on the input pin of a microprocessor, where this change of state is measured.

A voltage can be measured across an isolation barrier by charging a fully discharged capacitor through a resistor for a fixed period of time. This provides a fixed and known charge on the capacitor. This capacitor is then discharged through the diode half of the opto-isolator. The discharging capacitor turns on the transistor half of the opto-isolator, producing a pulse width that can be measured by the microprocessor. The width of the pulse is proportional to the charge on the capacitor, thus the voltage can be calculated.

A problem associated with the above method is that opto-isolators have a property called 'current transfer ratio' that dictates the diode current at which the transistor will switch off. As the capacitor discharges, the current flowing through the diode drops exponentially until a threshold level is reached, at which point the transistor stops conducting. This current transfer ratio is highly variable within a batch of opto-isolators and can vary, in some cases, by a factor of ten. Therefore, different opto-isolators within a batch can produce different pulse widths for the same voltage measured. This is obviously undesirable and is likely to result in inaccurate voltage measurements being recorded.

It is therefore an aim of the present invention to provide voltage measuring apparatus for accurately measuring voltage across an isolation barrier.

According to a first aspect of the present invention there is provided apparatus for measuring voltage across an isolation barrier, said apparatus including a voltage input and a voltage output, an opto-isolator provided between said voltage input and voltage output, processing means provided at said voltage output to measure and/or monitor pulse width and characterised in that circuitry is provided with means to allow a substantially constant current to flow through said opto-isolator.

In one embodiment the isolator barrier is provided in a telephone system, and typically between a telephone line and one or more items of telecom equipment. (i.e., to isolate the user from the telephone network for safety reasons).

Preferably a circuitry arrangement including two transistors and two resistors is provided to allow a substantially constant current to flow through said opto-isolators.

Preferably the capacitor is charged through a switch arrangement, the switch being open when the capacitor is charging and being closed when the capacitor is being discharged through the optoisolator.

Preferably two capacitors are provided in parallel to increase the capacitance of the charge that can be stored.

According to a second aspect of the present invention there is provided a method of measuring a voltage across an isolation barrier, said isolation barrier including an opto-isolator located between a voltage input and a voltage output, and processing means provided at said voltage output to measure and/or monitor pulse width, said method including the steps of discharging one or more charged capacitors through a light emitting diode half of said opto-isolator and characterised in that said capacitors are discharged through said opto-isolator at substantially constant current.

Voltage is applied to a capacitor for a pre-determined period of time to produce a proportionate charge in the capacitor(s). The charge on the capacitor is then discharged at a constant current through the opto-isolator to produce an isolated pulse, the width of which is proportionate to the voltage to be measured.

An advantage of the present invention is that measurement accuracy can be substantially improved by discharging the capacitor through the diode half of the opto-isolator at a constant current. If this current is high enough to guarantee conduction of the transistor half of the opto-isolator for all values of current transfer ratio for the selected device, then the constant charge held by the fixed value capacitor will produce a more accurate and repeatable pulse width from the transistor half of the opto-isolator. This width of the output pulse will now not be affected by the variability of the properties of the opto-isolator.

A further advantage is that the apparatus provides a non-intrusive means of measuring voltage across telephone lines in that it draws only a small amount of current from the circuitry voltage, thereby avoiding disturbance of the telephone lines.

An embodiment of the present invention will now be described with reference to the accompanying figures wherein:
Figure 1a is a graphical representation showing the current passing through an opto-isolator over time according to the present invention;
Figure 1b is a graphical representation showing the current passing through an opto-isolator over time using conventional circuitry; and
Figure 2 is an example of a circuit arrangement according to the present invention.

Voltage is measured across an isolation barrier between telecoms equipment and a telephone line to prevent unsafe voltages from being applied to the network by the equipment in the event of equipment malfunction.

The isolation barrier is typically provided by an opto-isolator comprising two halves; a diode half and a transistor half, separated by a physical gap.

In conventional circuitry, a fully discharged capacitor is charged through a resistor for a pre-determined period of time. This provides a fixed and known charge on the capacitor. The capacitor is then discharged through the diode half of the opto-isolator, which in turn activates the transistor. Current flows through the transistor and causes a pulse width change in the input pin of a microprocessor, where this change in state is detected. The width of the pulse is proportional to the charge on the capacitor and thus the voltage can be calculated.

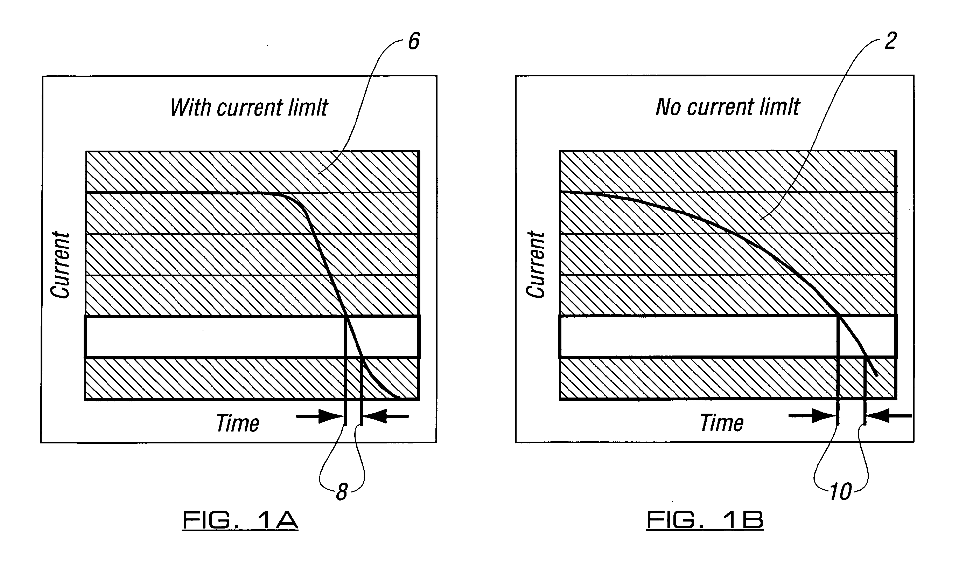

A problem associated with the conventional circuitry is that as the capacitor discharges through the diode half of the opto-isolator, the current flowing through the diode drops exponentially, as shown by plot 2 of current vs time in Figure 1b, until a threshold level 4 is reached. At the threshold level 4, the transistor stops conducting. This threshold level is known and can be highly variable between opto-isolators, sometimes varying by up to a factor of ten. Thus different opto-isolators can produce different measured voltages.

It can be seen that the circuitry of the present invention allows a substantially constant current to flow through the diode of the opto-isolator, above the threshold current level 4 required, until the charge from the capacitor is nearly exhausted, at which point the current will drop rapidly below the threshold 4. This is shown by plot 6 in Figure 1a. The rapid drop in current reduces the variability of the output voltage measured. Thus the output voltage is largely independent of the current transfer ratio of the opto-isolator.

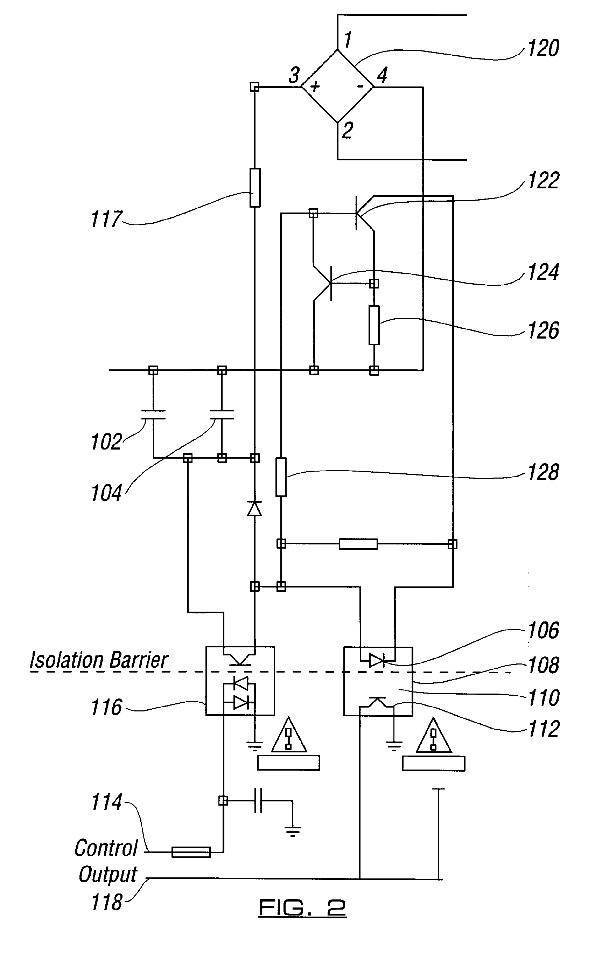

Referring to Figure 2, there is illustrated an example of a circuit according to the present invention which allows a substantially constant current to flow through the diode half of an opto-isolator.

A known amount of charge is stored on two parallel capacitors 102 and 104 by charging the capacitors through a fixed resistor for a pre-determined period of time. The capacitors 102 and 104 are then discharged at a constant current through the light emitting diode half 106 of the opto-isolator 108. The constant current remains above threshold current level required to operate the opto-isolator until the charge is almost exhausted from the capacitors 102 and 104.

The current passing through light emitting diode 106 causes the diode to illuminate. This light is directed across the isolation barrier 110 onto light sensitive transistor 112, which forms the other half of opto-isolator 108.

Light falling onto transistor 112 causes the transistor to conduct, allowing current to flow across the collector and emitter of the transistor.

The capacitors are fully discharged by raising the control voltage at 114 to +5V and waiting for 1 second. This causes the capacitors 102 and 104 to discharge through switch arrangement 116 and opto-isolator 108. The control voltage at 114 is then lowered to begin charging of the two capacitors 102 and 104 via resistor 117 and bridge rectifier 120. The bridge rectifier is used because although the network provides a DC voltage across 2 pins on the telephone socket, the polarity of this voltage cannot be guaranteed by the provider, and thus the rectifier converts a voltage of unknown polarity to a voltage of known polarity. After a pre-determined period of time, the capacitors are charged to a known amount which is proportional to the current to be measured. The two capacitors are then discharged by increasing the control voltage input 114 and measuring the width of the pulse generated at output 118.

In the embodiment shown, the arrangement of transistors 122 and 124, together with resistors 126 and 128 provide the constant current feed through the diode half of the opto-isolator. It is noted that other circuit arrangements can be used to provide constant current through the opto-isolator.

Thus, if one again refers to Fig 1a which represents the invention and Fig. 1b which represents the conventional system, the descending lines 8 and 10 on the x-axes of figures 1a and 1b represent the variability of the output pulse produced when the transistor portion of the opto-isolator will switch off, thereby indicating the variability in voltage measured across the isolation gap. It can be seen clearly that the circuit of the present invention as shown in Fig 1a significantly reduces the variability in pulse width compared to conventional circuitry, thereby providing a more accurate determination of the voltage being measured. The gradient of the capacitor discharge on the Figure 1a using the circuit of the present invention is substantially zero whereas the gradient of the capacitor discharge through the opto-isolator in Figure 1b in the conventional system is greater than zero.

## Claims

1. Apparatus for measuring voltage across an isolation barrier, said apparatus including a voltage input and a voltage output, an opto-isolator provided between said voltage input and voltage output, processing means provided at said voltage output to measure and/or monitor pulse width and **characterised in that** circuitry is provided with means to allow a substantially constant current to flow through said opto-isolator.

2. Apparatus according to claim 1 **characterised in that** the isolation barrier is provided in a telephone system.

3. Apparatus according to claim 1 **characterised in that** the substantially constant current is provided by a circuitry arrangement including two transistors and two resistors.

4. Apparatus according to claim 1 **characterised in that** at least one capacitor is provided to discharge through the opto-isolator to provide said substantially constant current.

5. Apparatus according to claim 4 **characterised in that** two capacitors are provided in parallel to discharge through the opto-isolator to provide said substantially constant current.

6. Apparatus according to claim 4 **characterised in that** the capacitor is charged through a switch arrangement, the switch in said arrangement being open when said capacitor is being charged.

7. A method of measuring voltage across an isolation barrier, said isolation barrier including an opto-isolator located between a voltage input and a voltage output, and processing means provided at said voltage output to measure and/or monitor pulse width, said method including the steps of discharging one or more charged capacitors through a light emitting diode half of said opto-isolator and **characterised in that** said capacitors are discharged through said opto-isolator at substantially constant current.
